# EUROPÄISCHE PATENTSCHRIFT

(11) **EP 3 334 800 B1**
(45) Veröffentlichungstag und Bekanntmachung des Hinweises auf die Patenterteilung: **02.10.2019**
(21) Anmeldenummer: 16753308.2
(22) Anmeldetag: 05.08.2016
(51) Int. Cl.: C09K 11/08, H01L 33/50, C09K 11/02

(54) **VERFAHREN ZUR HERSTELLUNG EINES KONVERSIONSELEMENTS**
METHOD FOR PRODUCING A CONVERSION ELEMENT
PROCÉDÉ DE FABRICATION D'UN ÉLÉMENT DE CONVERSION

(30) Priorität: 13.08.2015 DE 102015113360
(43) Veröffentlichungstag der Anmeldung: 20.06.2018
(73) Patentinhaber: OSRAM Opto Semiconductors GmbH, 93055 Regensburg (DE)
(72) Erfinder: SCHMIDTKE, Kathy, 84048 Mainburg (DE)
(74) Vertreter: Epping - Hermann - Fischer
(86) Internationale Anmeldenummer: PCT/EP2016/068783
(87) Internationale Veröffentlichungsnummer: WO 2017/025473

(56) Entgegenhaltungen:
- WO-A1-2010/037702
- US-A- 4 973 462
- LÜ XINGDONG: "Silica encapsulation study on SrAl2O4:Eu2+, Dy3+phosphors", MATERIALS CHEMISTRY AND PHYSICS, ELSEVIER SA, SWITZERLAND, TAIWAN, REPUBLIC OF CHINA, Bd. 93, Nr. 2, 25. April 2005 (2005-04-25) , Seiten 526-530, XP029052113, ISSN: 0254-0584, DOI: 10.1016/J.MATCHEMPHYS.2005.04.002

## Beschreibung

Die Erfindung betrifft ein Verfahren zur Herstellung eines Konversionselements für ein optoelektronisches Bauelement.

In optoelektronischen Bauelementen, insbesondere in anorganischen Leuchtdioden, werden Konversionselemente eingesetzt, um die von einem optoelektronischen Halbleiterchip emittierte Strahlung in eine Strahlung mit veränderter Wellenlänge, insbesondere längerer Wellenlänge, zu konvertieren. Das Konversionselement weist in der Regel Silikon oder eine Keramik als Matrixmaterial auf, in dem ein Konversionsmaterial eingebettet ist. Allerdings weisen die insbesondere aus Silikon aufweisenden Konversionselemente eine geringe Alterungsstabilität auf.

Die Druckschrift Lü, X.: "Silica encapsulation study on SrAl204:Eu2+,Dy3+ phosphors", Elsevier, Materials Chemistry and Physics, 2005, pp. 526-530 beschreibt eine Silica-Verkapselungsstudie an SrAl204:Eu2+,Dy3+ ein Verfahren zur Herstellung eines Konversionselements.

Eine Aufgabe der Erfindung ist es, ein Verfahren zur Herstellung eines Konversionselements für ein optoelektronisches Bauelement bereitzustellen, das ein stabiles Konversionselement zur Verfügung stellt. Insbesondere weist das Konversionselement eine hohe Temperatur- und/oder Lichtbeständigkeit und/oder Alterungsstabilität auf. Eine weitere Aufgabe der Erfindung ist es, ein kostengünstiges Verfahren zur Herstellung eines Konversionselements für ein optoelektronisches Bauelement bereitzustellen.

Diese Aufgaben werden durch ein Verfahren zur Herstellung eines Konversionselements für ein optoelektronisches Bauelement gemäß dem unabhängigen Anspruch 1 gelöst.

Vorteilhafte Ausgestaltungen und Weiterbildungen der Erfindung sind Gegenstand der abhängigen Ansprüche.

In zumindest einer Ausführungsform weist das Verfahren zur Herstellung eines Konversionselements für ein optoelektronisches Bauelement die Schritte auf:
A) Bereitstellen eines sauren Mediums mit einem pH-Wert von kleiner als 2,
B) Zugabe eines Konversionsmaterials in das saure Medium,
C) Zugabe einer Silikatlösung mit einer Viskosität von 2 bis 10000 Poise zu dem unter Schritt B) erzeugten Gemisches derart, dass der pH-Wert während der Zugabe im Schritt C) kleiner als 2 ist, wobei ein Niederschlag erhalten wird, der das Konversionsmaterial und Siliziumdioxid als Matrixmaterial umfasst,
D) Abtrennen des Niederschlags,
E) Waschen des Niederschlags mit einem Waschmedium, wobei das Waschmedium einen pH-Wert von kleiner als 2 aufweist, und
F) Härten des Niederschlags zur Erzeugung des Konversionselements.

Das mit dem Verfahren hergestellte Konversionselement ist insbesondere dazu eingerichtet, im Betrieb des optoelektronischen Bauelements die von einem optoelektronischen Halbleiterchip emittierte Strahlung zu absorbieren und in eine Strahlung mit veränderter Wellenlänge, insbesondere längerer Wellenlänge, zu emittieren. Insbesondere weist die konvertierte Strahlung eine Wellenlänge oder ein Wellenlängenmaximum im sichtbaren Bereich auf.

Gemäß zumindest einer Ausführungsform handelt es sich bei dem optoelektronischen Bauelement um eine Leuchtdiode, kurz LED. Das optoelektronische Bauelement ist dann bevorzugt dazu eingerichtet, blaues Licht, grünes Licht, rotes Licht oder weißes Licht zu emittieren.

Gemäß zumindest einer Ausführungsform weist das optoelektronische Bauelement einen optoelektronischen Halbleiterchip auf. Der optoelektronische Halbleiterchip weist eine Halbleiterschichtenfolge auf. Die Halbleiterschichtenfolge beinhaltet eine aktive Schicht mit mindestens einem pn-Übergang und/oder mit einem oder mit mehreren Quantentopfstrukturen. Die Halbleiterschichtenfolge des Halbleiterchips basiert bevorzugt auf einem III-V-Verbindungshalbleitermaterial. Bei dem Halbleitermaterial handelt es sich bevorzugt um ein Nitrid-Verbindungshalbleitermaterial wie AlₙIn₁₋ₙ₋ₘGaₘN oder auch um ein Phosphid-Verbindungshalbleitermaterial wie AlₙIn₁₋ₙ₋ₘGaₘP, wobei jeweils 0 ≤ n ≤ 1, 0 ≤ m ≤ 1 und n + m ≤ 1 ist. Ebenso kann es sich bei dem Halbleitermaterial um AlₓGa₁₋ₓAs handeln mit 0 ≤ x ≤ 1. Dabei kann die Halbleiterschichtenfolge Dotierstoffe sowie zusätzliche Bestandteile aufweisen. Der Einfachheit halber sind jedoch nur die wesentlichen Bestandteile des Kristallgitters der Halbleiterschichtenfolge, also Al, As, Ga, In, N oder P, angegeben, auch wenn diese teilweise durch geringe Mengen weiterer Stoffe ersetzt und/oder ergänzt sein können.

Im Betrieb des Halbleiterchips wird in der aktiven Schicht eine elektromagnetische Strahlung erzeugt. Eine Wellenlänge oder das Wellenlängenmaximum der Strahlung liegt bevorzugt im ultravioletten und/oder sichtbaren und/oder IR-Spektralbereich, insbesondere bei Wellenlängen zwischen einschließlich 420 nm bis einschließlich 800 nm, zum Beispiel zwischen einschließlich 440 nm und einschließlich 480 nm.

Das hier beschriebene Verfahren weist insbesondere die Verfahrensschritte A) bis F) auf. Insbesondere erfolgen die Verfahrensschritte A) bis F) in der besagten Reihenfolge. Zusätzlich kann insbesondere vor dem Verfahrensschritt F) ein zusätzlicher Verfahrensschritt H) erfolgen. Nach dem Verfahrensschritt F) kann ein zusätzlicher Verfahrensschritt G) und/oder I) erfolgen.

Gemäß zumindest einer Ausführungsform weist das Verfahren einen Verfahrensschritt A) auf, Bereitstellen eines sauren Mediums mit einem pH-Wert von kleiner als 2.

Gemäß zumindest einer Ausführungsform ist das saure Medium aus einer Gruppe ausgewählt, die Salzsäure, Phosphorsäure, Salpetersäure, Schwefelsäure, Chlorsulfonsäure, Sulforylchlorid, Perchlorsäure und Kombinationen daraus umfasst.

Gemäß zumindest einer Ausführungsform kann das saure Medium in konzentrierter oder verdünnter Form vorliegen. Mit konzentrierter Form ist hier und im Folgenden gemeint, dass das saure Medium ohne Zusatz von Wasser vorliegt. Beispielsweise bedeutet eine Schwefelsäure in konzentrierter Form, dass die Schwefelsäure 94 bis 96 %ig ist. Ein verdünntes saures Medium bedeutet hier und im Folgenden, dass dem sauren Medium Wasser zugesetzt ist. Damit kann aus einem konzentrierten Medium, beispielsweise einer 94 bis 96 %igen Schwefelsäure, durch Zugabe von Wasser ein verdünntes saures Medium, wie eine verdünnte Schwefelsäure erzeugt werden. Insbesondere ist der pH-Wert des verdünnten sauren Mediums kleiner als 2.

Insbesondere kann das saure Medium unterschiedliche Normalitäten aufweisen. Beispielsweise kann die Salzsäure eine Normalität zwischen 2 N bis 14 N, beispielsweise zwischen 3 N bis 6 N, aufweisen. Die Phosphorsäure kann eine Normalität zwischen 2 bis 59 N, beispielsweise zwischen 4 bis 20 N, aufweisen. Die Salpetersäure kann eine Normalität zwischen 1 bis 24 N, beispielsweise zwischen 1 bis 15 N, aufweisen. Die Schwefelsäure kann eine Normalität zwischen 1 bis 37 N, beispielsweise zwischen 2 bis 10 N, aufweisen. Insbesondere wird als saures Medium Schwefelsäure verwendet.

Gemäß zumindest einer Ausführungsform weist das saure Medium zusätzlich Wasser auf. Insbesondere ist das Wasser destilliertes Wasser oder VE-Wasser.

Gemäß zumindest einer Ausführungsform weist das saure Medium einen pH-Wert von kleiner als 2 auf. Insbesondere weist das saure Medium einen pH-Wert von kleiner als 1,5, insbesondere von kleiner als 1, bevorzugt von kleiner als 0,5, auf.

Der pH-Wert kann mittels Potentiometrie oder durch ionensensitive Feldeffekttransistoren oder durch die Reaktion von Indikatorfarbstoffen bestimmt werden. Insbesondere kann der pH-Wert mittels eines pH-Meters bestimmt werden.

Gemäß zumindest einer Ausführungsform weist das Verfahren einen Schritt B) auf, Zugabe eines Konversionsmaterials in das saure Medium. Das Konversionsmaterial kann aus einer Gruppe ausgewählt sein, die (Y,Lu,Gd,Tb)₃(Al₁₋ₓGaₓ)₅O₁₂, (Ba,Sr,Ca)Si₂O₂N₂, (Ba,Sr,Ca)₂SiO₄, (Ba,Sr,Ca)₂Si₅N₈, (Sr,Ca)AlSiN₃·Si₂N₂O, (Sr,Ca)AlSiN₃ und Ca₈Mg(SiO₄)₄Cl₂ umfasst.

Gemäß zumindest einer Ausführungsform ist das Konversionselement als Schicht ausgeformt. Insbesondere weist das Konversionselement eine Schichtdicke von 40 µm bis 60 µm, beispielsweise 50 pm, auf.

Gemäß zumindest einer Ausführungsform ist das Konversionsmaterial als Partikel ausgeformt. Insbesondere weist das Konversionsmaterial eine mittlere Korngröße zwischen einschließlich 5 bis 30 pm, insbesondere zwischen einschließlich 10 bis 30 pm, bevorzugt zwischen 15 bis 30 pm, auf.

Gemäß zumindest einer Ausführungsform wird im Verfahrensschritt B) das Konversionsmaterial homogen in das saure Medium eindispergiert. Dies kann beispielsweise mittels Rühren oder Schütteln erfolgen.

Gemäß zumindest einer Ausführungsform können im Schritt B) zusätzlich Streupartikel eindispergiert werden. Als Streupartikel eignen sich jegliche Materialien, die zur Reflexion und/oder Streuung von elektromagnetischer Strahlung eingerichtet sind. Beispielsweise können Streupartikel aus Titandioxid und/oder Al₂O₃ eindispergiert werden. Insbesondere weisen die Streupartikel einen durchschnittlichen Durchmesser zwischen einschließlich 0,5 µm bis einschließlich 1 µm auf.

Gemäß Zumindest einer Ausführungsform weist das Konversionsmaterial einen Anteil von einschließlich 50 Gew% bis einschließlich 60 Gew%, beispielsweise zwischen 55 und 57 Gew%, in dem Matrixmaterial auf.

Gemäß zumindest einer Ausführungsform weist das Verfahren einen Schritt C) auf, Zugabe einer Silikatlösung mit einer Viskosität von 2 bis 10000 Poise zu dem unter Schritt B) erzeugten Gemisches derart, dass der pH-Wert während der Zugabe in Schritt C) kleiner als 2 ist, wobei ein Niederschlag erhalten wird, der das Konversionsmaterial und Siliziumdioxid als Matrixmaterial umfasst.

Gemäß zumindest einer Ausführungsform ist die Silikatlösung im Schritt C) eine Lösung aus Wasserglas, insbesondere aus einem Natronwasserglas, Kaliwasserglas oder Lithiumwasserglas.

Mit Wasserglas wird hier und im Folgenden ein Alkalisilikat mit unterschiedlichen Anteilen von Alkalioxiden, wie Na₂O und/oder K₂O, bezeichnet. Unter Natronwasserglas kann beispielsweise ein hochkonzentriertes Wasserglas mit einem SiO₂-Gehalt von 36 bis 37 Gew% und einem Na₂O-Gehalt von 17,8 bis 18,4 Gew% und einer Viskosität bei 20 °C von zirka 600 Poise bezeichnet werden. Die Silikatlösung kann von unterschiedlichen Herstellern, beispielsweise von der Firma Van Baerle Chemische Fabrik, bezogen werden. Silikatlösungen sind dem Fachmann, beispielsweise aus der WO 2010/037702 A1, bekannt und werden daher an dieser Stelle nicht weiter erläutert.

Die Silikatlösung weist insbesondere eine Viskosität von 2 bis 10000 Poise, bevorzugt zwischen 3 bis 5000 Poise, besonders bevorzugt zwischen 4 bis 1000 Poise und ganz besonders bevorzugt zwischen 4 und 800 Poise, ganz speziell bevorzugt zwischen 4 bis 100 Poise und insbesondere bevorzugt zwischen 5 und 50 Poise, auf. Die Viskosität kann mittels eines Kugelfallviskosimeters bestimmt werden.

Die Silikatlösung wird zu dem Gemisch aus dem Konversionsmaterial und dem sauren Medium in Schritt C) hinzugegeben. Insbesondere ist der pH-Wert jederzeit, also während der gesamten Zugabe in Schritt C), kleiner als 2, insbesondere kleiner als 1,5, insbesondere kleiner als 1 und bevorzugt kleiner als 0,5.

Gemäß zumindest einer Ausführungsform erfolgt die Zugabe der Silikatlösung in Tropfenform in das Gemisch aus dem Konversionsmaterial und dem sauren Medium. Beispielsweise kann das Zutropfen der Silikatlösung mittels Sprühaggregate, Tropfengeneratoren, Prillteller, erfolgen. Diese Methoden sind dem Fachmann bekannt und werden daher nicht näher erläutert. Durch die Zugabe der Silikatlösung in Tropfenform kann ein gut filtrierbarer Niederschlag erhalten werden.

Der Niederschlag ist insbesondere eine Suspension. Der Niederschlag enthält das Siliziumdioxid als Matrixmaterial und das Konversionsmaterial.

Gemäß zumindest einer Ausführungsform wird der Verfahrensschritt C) bei einer Temperatur von 20 bis 95 °C, bevorzugt zwischen 30 bis 90 °C, beispielsweise zwischen 40 bis 80 °C, durchgeführt. Insbesondere wird die Temperatur im Schritt C) auf dieser Temperatur gehalten.

Gemäß zumindest einer Ausführungsform weist das Verfahren einen Schritt D) auf, Abtrennen des Niederschlags. Mit anderen Worten wird der Niederschlag von den restlichen Bestandteilen des Gemisches abgetrennt. Dies kann je nach Filtrierbarkeit des Niederschlags durch dem Fachmann bekannte Filtrationstechniken erfolgen. Beispielsweise kann der Niederschlag mittels Filterpressen oder Drehfiltern erfolgen. Alternativ kann der Niederschlag auch durch Zentrifugation und/oder durch Abdekantieren der flüssigen Bestandteile des Niederschlages erfolgen.

Gemäß zumindest einer Ausführungsform weist das Verfahren einen Schritt E) auf, Waschen des Niederschlags mit einem Waschmedium, wobei das Waschmedium einen pH-Wert von kleiner als 2, insbesondere einen pH-Wert von kleiner 1,5 oder 1 oder 0,5, aufweist. Als Waschmedium können die im Schritt A) bereits genannten sauren Medien verwendet werden.

Alternativ kann als Waschmedium eine Chelatierungsreagenz zugegeben werden.

Gemäß zumindest einer Ausführungsform wird ein Indikator in zumindest einem der Schritte A) bis D), insbesondere im Schritt A), aus einem Peroxid zugegeben. Der Indikator gibt insbesondere einen Farbumschlag an und zeigt damit die Vollständigkeit der Ausfällung des Niederschlags an. Insbesondere kann dies nicht auf LED-Basis, sondern auf Materialebene stattfinden.

Insbesondere weist das Peroxid Titan(IV)-Ionen auf. Insbesondere wird als Indikator Wasserstoffperoxid oder Kaliumperoxidisulfat, das die Titan(IV)-Ionen umfasst, verwendet. Die Titan(IV)-Ionen weisen unter sauren Bedingungen eine Gelb-Orange-farbene Färbung auf. Durch die Gelb-Orange-farbene Färbung des Gemisches kann der Grad der Aufreinigung, beispielsweise während des Waschschrittes E), kontrolliert werden. Da sich bereits bei pH-Werten über 2 das Titan leicht an den entstehenden Niederschlag anlagert und damit eine sehr hartnäckige Verunreinigung darstellt, kann damit der Reinigungsgrad des Niederschlages kontrolliert werden.

Der Verfahrensschritt E) kann so lange durchgeführt werden, bis visuell keine Gelb-Orange-farbene Färbung des Indikators gezeigt ist.

Alternativ oder zusätzlich kann der Verfahrensschritt E) auch mit einem Waschmedium aus destilliertem Wasser oder VE-Wasser durchgeführt werden. Insbesondere wird so lange gewaschen, bis das Filtrat, also die Waschsuspension, eine Leitfähigkeit von kleiner oder gleich 9 pS/cm, bevorzugt kleiner oder gleich 5 pS/cm, beträgt. Die Leitfähigkeit kann mittels eines Leitfähigkeitsmessgerätes bestimmt werden.

Der Verfahrensschritt E) kann bevorzugt bei Temperaturen von 15 bis 100 °C durchgeführt werden.

Gemäß zumindest einer Ausführungsform weist das Verfahren einen Verfahrensschritt F) auf, Härten des Niederschlags zur Erzeugung des Konversionselements.

Gemäß zumindest einer Ausführungsform wird die Härtung im Schritt F) mittels eines Gasstroms durchgeführt. Zusätzlich kann die Härtung im Verfahrensschritt F) unter Druck erfolgen. Der Druck kann durch eine Presse erfolgen. Der Druck kann beispielsweise zwischen 80 und 150 bar, beispielsweise 100 bar, betragen. Der Gasstrom kann ein Gasdampf, beispielsweise ein Wasserdampf, sein. Der Kontakt des Niederschlags mit dem Gasstrom und gegebenenfalls unter Druck führt zu einem Härten und zum Verfestigen des Konversionselements.

Alternativ oder zusätzlich können die Verfahrensschritte auch mehrmals durchgeführt werden, so dass ein Schichtsystem aus dem Konversionsmaterial und dem Matrixmaterial erzeugt wird. Insbesondere wird zusätzlich der Farbort eingestellt.

Zusätzlich kann vor Schritt F) der Niederschlag in eine Form überführt werden. Insbesondere ist der Niederschlag bei Überführen in die Form gelartig.

Die Form kann jede beliebige Gestalt annehmen. Beispielsweise kann die Form in Draufsicht eine Rechteckform mit einer Fläche von beispielsweise 1 mm², 2 mm² oder 750 µm oder eine Barenform aufweisen. Die Form kann eine Kavität aufweisen, in die der Niederschlag eingebracht wird. Die Kavität kann ein Loch aufweisen. Insbesondere werden durch das Loch die im Schritt F) erzeugten Nebenprodukte, wie Wasser, abgeführt. Gemäß zumindest einer Ausführungsform weist die Form ein Sieb auf. Dadurch kann der Gasstrom das Konversionselement vollständig durchdringen und die wässrigen Bestandteile können aus dem Konversionselement austreten, sodass das Konversionselement vollständig aushärten kann.

Gemäß zumindest einer Ausführungsform erfolgt vor Schritt F) ein zusätzlicher Schritt H), Aufbringen des nach Schritt E) gewaschenen Niederschlags auf einen optoelektronischen Halbleiterchip mittels Spraycoating. Insbesondere wird die Viskosität des Niederschlags auf die Prozessviskosität eingestellt.

Gemäß zumindest einer Ausführungsform weist das Verfahren nach Schritt F) einen zusätzlichen Schritt G) auf, Aufbringen des Konversionselements auf einen optoelektronischen Halbleiterchip. Insbesondere wird das Konversionselement in einem sogenannten Pick-and-Place-Prozess, also als vorgefertigter Körper, auf eine Strahlungsaustrittsfläche des Halbleiterchips aufgebracht. Das Aufbringen kann in direktem oder indirektem, also in unmittelbarem mechanischem und/oder elektrischem Kontakt oder in mittelbarem mechanischem oder elektrischem Kontakt, erfolgen. Bei mittelbarem elektrischem oder mechanischem Kontakt kann eine weitere Schicht, beispielsweise eine Kleberschicht, zwischen dem Konversionselement und dem optoelektronischen Halbleiterchip angeordnet sein.

Insbesondere weist das Konversionselement scharfe Kanten auf. Mit anderen Worten ist das Konversionselement vieleckig, beispielswiese quaderförmig ausgeformt, wobei die Kanten beim Übergang von einer Quaderfläche zur anderen Quaderfläche nicht abgerundet sind. Insbesondere sind die Seitenflächen des Konversionselements formschlüssig in Draufsicht auf die Strahlungsaustrittsfläche mit den Seitenflächen des Halbleiterchips angeordnet.

Gemäß zumindest einer Ausführungsform erfolgt nach Schritt F) ein zusätzlicher Schritt I), Schleifen des Konversionselements. Damit kann die Lichtauskopplung des Konversionselements erhöht werden.

Mit dem hier beschriebenen Verfahren kann ein Konversionselement bereitgestellt werden, das ein sehr sauberes und hochreines Matrixmaterial aus Siliziumdioxid aufweist, in dem das Konversionsmaterial eindispergiert ist. Insbesondere ist das Konversionsmaterial homogen in dem Matrixmaterial verteilt. Mit der Fällung des Niederschlags in Kombination mit dem Konversionsmaterial kann insbesondere ein alternatives Konversionselement bereitgestellt werden. Das Konversionselement ist zudem kostengünstig und zuverlässig herstellbar. Ferner weist das Konversionselement keine Alterung auf. Ferner können in das Konversionselement beliebige Leuchtstoffe oder Mischungen der Leuchtstoffe eindispergiert werden. Das Konversionselement kann eine flexible Form aufweisen.

Es wird weiterhin ein Konversionselement angegeben. Das Konversionselement wird vorzugsweise mit dem Verfahren zur Herstellung eines Konversionselements für ein optoelektronisches Bauelement hergestellt. Das heißt, sämtliche für das Verfahren zur Herstellung eines Konversionselements offenbarten Merkmale sind auch für das Bauelement offenbart und umgekehrt.

Das Konversionselement umfasst insbesondere ein Konversionsmaterial, das aus den oben beschriebenen Materialien ausgewählt sein kann. Zusätzlich weist das Konversionselement ein Matrixmaterial aus Siliziumdioxid auf. Das Siliziumdioxid ist insbesondere ein hochreines Siliziumdioxid. Mit hochreinem Siliziumdioxid wird hier und im Folgenden bezeichnet, dass der Gehalt von Verunreinigungen in dem Siliziumdioxid sehr gering ist. Insbesondere ist der Anteil an Aluminium in dem Siliziumdioxid kleiner als 1 ppm. Alternativ oder zusätzlich ist der Anteil an Bor in dem Siliziumdioxid kleiner als 0,1 ppm. Alternativ oder zusätzlich ist der Anteil an Kalzium in dem Siliziumdioxid kleiner als 0,3 ppm. Alternativ oder zusätzlich ist der Anteil an Eisen in dem Siliziumdioxid kleiner als 0,6 ppm. Alternativ oder zusätzlich ist der Anteil an Nickel kleiner als 0,5 ppm. Alternativ oder zusätzlich ist der Anteil an Phosphor in dem Siliziumdioxid kleiner als 0,1 ppm. Alternativ oder zusätzlich ist der Anteil an Titan kleiner gleich 1 ppm. Alternativ oder zusätzlich ist der Anteil an Zink kleiner oder gleich 0,3 ppm. Insbesondere ist die Summe der Verunreinigungen in dem Siliziumdioxid inklusive Natrium und Kalium kleiner 5 ppm, bevorzugt kleiner 4 ppm, besonders bevorzugt zwischen 0,5 und 3 ppm oder zwischen 1 bis 3 ppm.

Die Erfindung betrifft ferner ein optoelektronisches Bauelement. Vorzugsweise weist das optoelektronische Bauelement das oben beschriebene Konversionselement auf. Das heißt, sämtliche für das Verfahren zur Herstellung eines Konversionselements offenbarten Merkmale und Ausführungen sind auch für das Konversionselement offenbart und umgekehrt.

Gemäß zumindest einer Ausführungsform umfasst das optoelektronische Bauelement einen optoelektronischen Halbleiterchip. Dem optoelektronischen Halbleiterchip ist das Konversionselement nachgeordnet. Der optoelektronische Halbleiterchip und das Konversionselement sind insbesondere in einem Verguss, beispielsweise aus Silikon, eingebettet. Der Verguss kann ferner Streupartikel, beispielsweise aus Titandioxid, aufweisen. Zusätzlich kann der optoelektronische Halbleiterchip auf einem Träger oder Substrat angeordnet sein. Bei dem Träger oder Substrat kann es sich beispielsweise um einen Siliziumwafer handeln.

Die Erfindung betrifft ferner ein Verfahren zur Herstellung eines optoelektronischen Bauelements. Vorzugsweise stellt das Verfahren das optoelektronische Bauelement her. Das heißt, sämtliche für das Verfahren zur Herstellung eines Konversionselements, für das Konversionselement und/oder für das optoelektronische Bauelement offenbarten Merkmale und Ausführungen sind auch für das Verfahren zur Herstellung eines optoelektronischen Bauelements offenbart und umgekehrt.

Gemäß zumindest einer Ausführungsform weist das Verfahren, die Schritte auf:
A) Bereitstellen eines Trägers oder eines Substrats,
B) Aufbringen zumindest eines optoelektronischen Halbleiterchips auf das Substrat oder den Träger,
C) Aufbringen des Konversionselements auf den jeweiligen optoelektronischen Halbleiterchips, und
D) gegebenenfalls Vereinzeln von mehreren optoelektronischen Halbleiterchips.

Insbesondere kann vor oder nach Schritt C) der jeweilige optoelektronische Halbleiterchip mit einem Verguss umhüllt werden. Der Verguss kann aus Silikon sein, in dem zusätzlich Streupartikel eindispergiert sein können.

Gemäß zumindest einer Ausführungsform ist das aufgebrachte Konversionselement beständig gegenüber Temperatur und/oder elektromagnetischer Strahlung.

Die Erfinderin hat erkannt, dass durch das hier beschriebene Verfahren zur Herstellung eines Konversionselements ein kostengünstiges Konversionselement mit einem einfachen Matrixmaterial hergestellt werden kann. Ein wesentliches Verfahrensmerkmal ist dabei die Kontrolle des pH-Wertes des Matrixmaterials, insbesondere des Siliziumdioxids, sowie der Reaktionsmedien, in denen sich das Matrixmaterial und Konversionsmaterial während der verschiedenen Verfahrensschritte befindet. Ohne an eine bestimmte Theorie gebunden zu sein, ist die Erfinderin der Ansicht, dass durch einen sehr niedrigen pH-Wert sichergestellt wird, dass idealerweise keine freien negativ geladenen SiO-Gruppen auf der Siliziumdioxidoberfläche vorhanden sind und an die störenden Metallionen gebunden werden können. Bei sehr niedrigem pH-Wert ist die Oberfläche sogar positiv geladen, sodass Metallkationen von der Kieselsäureoberfläche abgestoßen werden. Werden die Metallionen nun ausgewaschen, solange der pH-Wert sehr niedrig ist, kann verhindert werden, dass sich diese an der Oberfläche des Matrixmaterials anlagern. Nimmt die Kieselsäureoberfläche eine positive Ladung an, so wird zudem verhindert, dass Kieselsäurepartikel sich aneinander anlagern und dadurch Hohlräume gebildet werden, in denen sich Verunreinigungen einlagern können. Das Verfahren kann somit ohne die Verwendung von Chelatierungsreagenzen und/oder von Ionenaustauschersäulen durchgeführt werden. Zusätzlich sind Kalzinierungsschritte nicht erforderlich. Das Verfahren zur Herstellung eines Konversionselements kann somit einfacher und kostengünstiger hergestellt werden.

Weitere Vorteile, vorteilhafte Ausführungsformen und Weiterbildungen ergeben sich aus den im Folgenden in Verbindung mit den Figuren beschriebenen Ausführungsbeispielen.

Es zeigen:
- Die Figuren 1A bis 1F: ein Verfahren zur Herstellung eines Konversionselements gemäß einer Ausführungsform,
- die Figuren 2A bis 2C: ein Verfahren zur Herstellung eines Konversionselements gemäß einer Ausführungsform, und
- die Figuren 3A bis 3F sowie die Figuren 4A bis 4F jeweils: ein Verfahren zur Herstellung eines optoelektronischen Bauelements gemäß einer Ausführungsform.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben groß dargestellt werden.

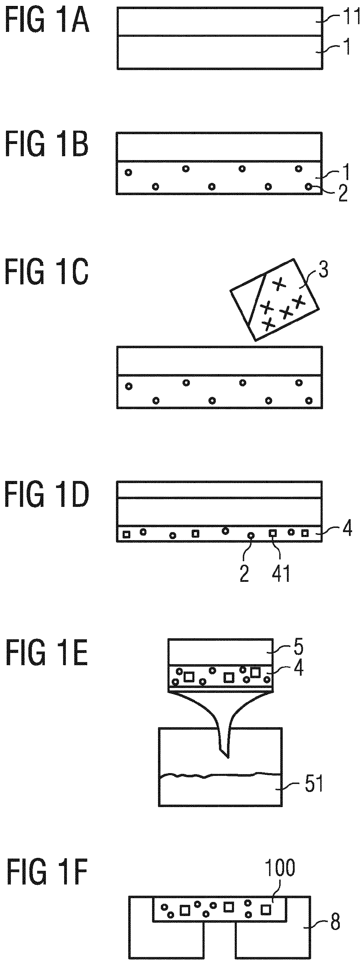

Die Figuren 1A bis 1F zeigen ein Verfahren zur Herstellung eines Konversionselements gemäß einer Ausführungsform. Die Figur 1A zeigt das Bereitstellen eines sauren Mediums 1 mit einem pH-Wert von kleiner als 2 in einem Behälter 11. Anschließend kann ein Konversionsmaterial 2, wie in Figur 1B gezeigt, zu dem sauren Medium 1 hinzugegeben werden. Anschließend kann, wie in Figur 1C gezeigt, zu diesem Gemisch aus dem Konversionsmaterial 2 und dem sauren Medium 1 eine Silikatlösung 3 hinzugegeben werden. Die Silikatlösung 3 weist insbesondere eine Viskosität von 2 bis 10000 Poise auf. Der pH-Wert während der Zugabe im Schritt C) ist dabei kleiner als 2. Es wird ein Niederschlag 4 erhalten, wie in Figur 1D gezeigt. Der Niederschlag 4 weist ein Konversionsmaterial 2 und Siliziumdioxid 41 als Matrixmaterial auf oder besteht aus diesen. Alternativ kann der Niederschlag 4 auch Streupartikel aufweisen, die beispielsweise im Verfahrensschritt B) hinzugegeben wurden (hier nicht gezeigt). Anschließend kann der Niederschlag 4, wie in Figur 1E gezeigt, abgetrennt werden. Der Niederschlag 4 kann beispielsweise filtriert werden. Es entsteht ein Filtrat 51. Anschließend kann die Waschung des Niederschlages 4 erfolgen (hier nicht gezeigt). Die Waschung kann mit einem Waschmedium 6, beispielsweise einem sauren Medium 1, das bereits im Verfahrensschritt A) bereitgestellt wurde, genutzt werden. Insbesondere ist der pH-Wert des Waschmediums kleiner als 2. Nach diesem Waschen mit dem sauren Medium 1 kann alternativ oder zusätzlich die Waschung mittels destilliertem Wasser erfolgen. Es entsteht ein Waschfiltrat als Nebenprodukt. Nach dem Verfahrensschritt E) des Waschens kann der Niederschlag 4 ausgehärtet werden. Dazu kann der Niederschlag 4 in eine Form, wie in Figur 1F gezeigt, überführt werden und die Härtung kann erfolgen. Die Härtung kann beispielsweise mittels eines Gasstroms und unter Druck, beispielsweise bei 100 bar, erfolgen.

Das Konversionselement 100, das zumindest nach Schritt F) ausgehärtet ist, weist insbesondere eine Härte auf, die der Härte des Siliziumdioxids, also einer Glashärte, entspricht.

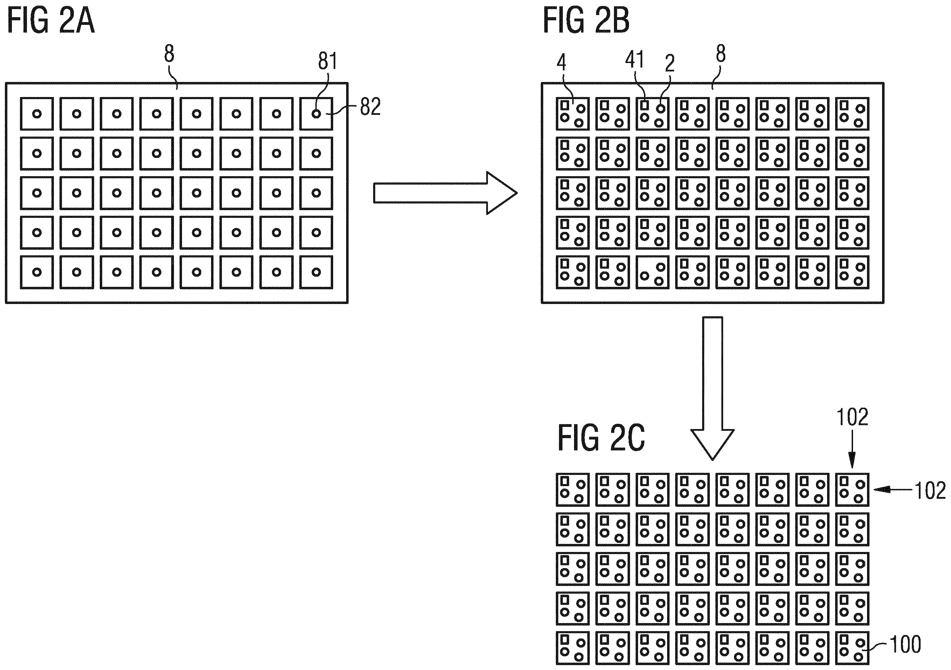

Die Figuren 2A bis 2C zeigen ein Verfahren zur Herstellung eines Konversionselements gemäß einer Ausführungsform. Die Figur 2A zeigt eine Form 8. Die Form 8 zeigt verschiedene Kavitäten 82, die jeweils ein Loch 81 aufweisen. In die Form 8 kann der Niederschlag 4, welcher insbesondere nach Schritt E) gewaschen wurde, eingefüllt werden (Figur 2B). Anschließend kann der Niederschlag 4 ausgehärtet werden (Schritt F). Dies kann mittels eines Gasstroms unter Druck, beispielsweise bei 100 bar, erfolgen. Das jeweilige Loch 81 ist insbesondere dazu eingerichtet, die bei der Härtung im Schritt F) ausscheidenden Nebenprodukte, wie Wasser, abzuführen. Es resultiert ein Konversionselement 100, das in Draufsicht eine rechteckige Form aufweist. Die Form des Konversionselements 100 ist nicht auf die Rechteckform begrenzt. Das Konversionselement 100 kann in jede beliebige Form überführt werden. Das Konversionselement 100 weist insbesondere scharfe Kanten 102 auf (Figur 2C).

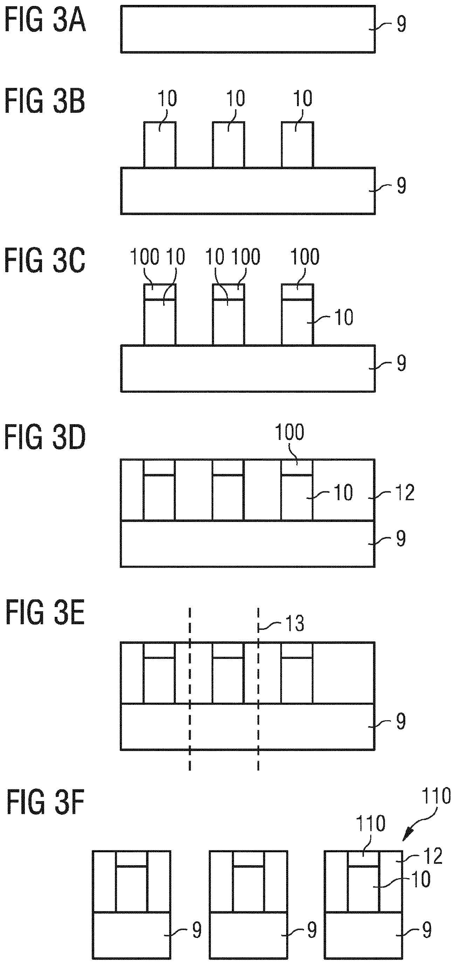

Die Figuren 3A bis 3F zeigen ein Verfahren zur Herstellung eines optoelektronischen Bauelements 110 gemäß einer Ausführungsform. Zur Herstellung wird ein Träger oder Substrat 9, beispielsweise ein Siliziumwafer, bereitgestellt (Figur 3A). Auf dieses Substrat 9 wird, wie in Figur 3B gezeigt, zumindest ein optoelektronischer Halbleiterchip 10 angeordnet. Insbesondere können auch mehr als ein optoelektronischer Halbleiterchip 10 auf das Substrat 9 angeordnet werden. Die Figur 3B zeigt beispielhaft die Anordnung von drei optoelektronischen Halbleiterchips 10. Den optoelektronischen Halbleiterchips 10 kann jeweils ein Konversionselement 100 nachgeordnet werden. Dieses Konversionselement 100 wird im sogenannten Pick-and-Place-Prozess, also als vorgefertigter Körper, insbesondere auf die Strahlungsaustrittsfläche 101 des optoelektronischen Halbleiterchips 10 angeordnet (Figur 3C). Insbesondere ist das Konversionselement 100 mit dem Verfahren gemäß dem Anspruch 1 hergestellt. Anschließend, wie in Figur 3D gezeigt, können die Halbleiterchips 10 vergossen werden. Dies kann beispielsweise mit einem Verguss 12 aus Silikon erfolgen. Der Verguss 12 kann zusätzlich Streupartikel, beispielsweise Titandioxid und/oder Al₂O₃, aufweisen (hier nicht gezeigt). Insbesondere ist der Verguss 12 bis zur oberen Konversionselementkante 100 angeordnet. Mit anderen Worten schließt die Oberfläche des Konversionselements 100 und die obere Fläche des Vergusses bündig miteinander ab. Insbesondere wird die bündige Herstellung durch die scharfen Kanten des Konversionselements 100 erzeugt. Der Verguss 12 ist insbesondere nicht auf der Oberfläche des Konversionselements 100 angeordnet, da sonst die Streupartikel, beispielsweise Titandioxid, eine Lichtauskopplung reduzieren würden. Anschließend kann der Verbund der Halbleiterchips 10 vereinzelt werden 13 (Figur 3E). Es resultieren, wie in Figur 3F gezeigt, optoelektronische Bauelemente 110, welche ein Substrat 9, einen Halbleiterchip 10, einen Verguss 12 und ein Konversionselement 110 aufweisen.

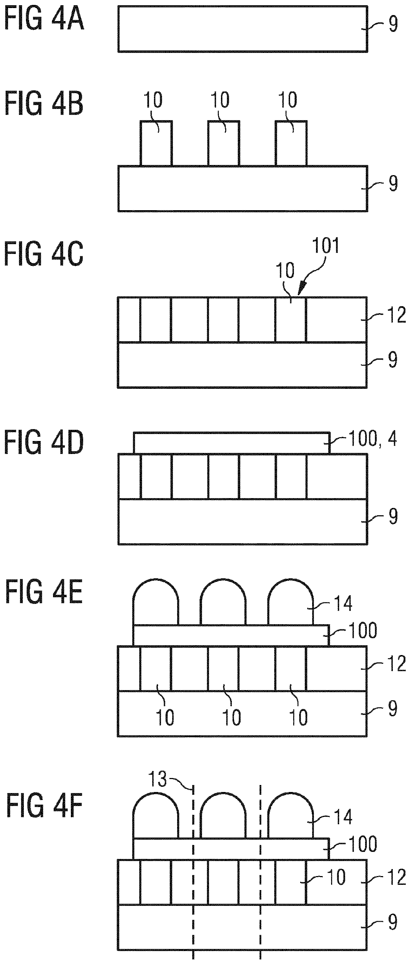

Die Figuren 4A bis 4F zeigen ein Verfahren zur Herstellung eines optoelektronischen Bauelements 110 gemäß einer Ausführungsform. Insbesondere weist das optoelektronische Bauelement 110 ein Konversionselement 100, wie oben beschrieben, auf. Die Figur 4A zeigt das Bereitstellen eines Substrates 9. Die Figur 4B zeigt die Anordnung zumindest eines Halbleiterchips 10 auf dem Substrat 9. Anschließend kann, wie in Figur 4C gezeigt, der optoelektronische Halbleiterchip 10 mittels eines Vergusses 12 vergossen werden. Mit anderen Worten sind die Seitenflächen des jeweiligen Halbleiterchips 10 in direktem mechanischem Kontakt mit dem Verguss 12. Insbesondere bleibt die jeweilige Strahlungsaustrittsfläche 101 des Halbleiterchips 10 frei von dem Verguss 12. Der Verguss 12 kann aus Silikon sein. Alternativ oder zusätzlich kann der Verguss 12 Streupartikel, wie Titandioxid, aufweisen. Anschließend kann, wie in Figur 4D gezeigt, der gewaschene Niederschlag 4 auf den optoelektronischen Halbleiterchip, insbesondere auf die Strahlungsaustrittsfläche 101 des optoelektronischen Halbleiterchips, angeordnet werden. Dies kann mittels Spraycoating erfolgen. Der Niederschlag 4 kann ausgehärtet werden, beispielsweise mittels eines Gasstroms oder mittels Dampf. Es entsteht das Konversionselement 100 auf dem optoelektronischen Halbleiterchip 10. Anschließend kann eine Linse 14 auf das Konversionselement 100 aufgebracht werden. Die Linse 14 ist insbesondere aus Silikon geformt. Anschließend kann der Verbund der optoelektronischen Bauelemente 110 vereinzelt 13 werden, wie in Figur 4F gezeigt.

Diese Patentanmeldung beansprucht die Priorität der deutschen Patentanmeldung 10 2015 113 360.1.

### Bezugszeichenliste

- 100: Konversionselement
- 110: optoelektronisches Bauelement
- 1: saures Medium
- 2: Konversionsmaterial
- 3: Silikatlösung
- 4: Niederschlag
- 41: Siliziumdioxid
- 5: Abtrennen
- 6: Waschmedium
- 7: Härten
- 8: Form
- 9: Substrat
- 10: optoelektronischer Halbleiterchip
- 11: Behälter
- 12: Verguss
- 13: Vereinzeln
- 14: Linse
- 51: Filtrat
- 101: Strahlungsaustrittsfläche des optoelektronischen Halbleiterchips
- 102: Kanten des Konverterelements
- 81: Loch
- 82: Kavität der Form

## Patentansprüche

1. Verfahren zur Herstellung eines Konversionselements (100) für ein optoelektronisches Bauelement (110) mit den Schritten:
A) Bereitstellen eines sauren Mediums (1) mit einem pH-Wert von kleiner als 2,
B) Zugabe eines Konversionsmaterials (2) in das saure Medium (1),
C) Zugabe einer Silikatlösung (3) mit einer Viskosität von 2 bis 10000 Poise zu dem unter Schritt B) erzeugten Gemisches derart, dass der pH-Wert während der Zugabe im Schritt C) kleiner als 2 ist, wobei ein Niederschlag (4) erhalten wird, der das Konversionsmaterial (2) und Siliziumdioxid (41) als Matrixmaterial umfasst,
D) Abtrennen des Niederschlags (4),
E) Waschen des Niederschlags (4) mit einem Waschmedium (6), wobei das Waschmedium (6) einen pH-Wert von kleiner als 2 aufweist,
F) Härten des Niederschlags (4) zur Erzeugung des Konversionselements (100).

2. Verfahren nach Anspruch 1,
wobei vor Schritt F) der Niederschlag (4) in eine Form (8) überführt wird und die Härtung (7) im Schritt F) mittels eines Gasstroms unter Druck erfolgt.

3. Verfahren nach Anspruch 2,
wobei die Form (8) ein Sieb umfasst.

4. Verfahren nach einem der vorhergehenden Ansprüche,
wobei das Konversionsmaterial (2) aus einer Gruppe ausgewählt ist, die (Y,Lu,Gd,Tb)₃(Al₁₋ₓGaₓ)₅O₁₂, (Ba,Sr,Ca)Si₂O₂N₂, (Ba,Sr,Ca)₂SiO₄, (Ba,Sr,Ca)₂Si₅N₈, (Sr,Ca)AlSiN₃·Si₂N₂O, (Sr,Ca)AlSiN₃ und Ca₈Mg(SiO₄)₄Cl₂ umfasst.

5. Verfahren nach einem der vorhergehenden Ansprüche,
wobei das Konversionsmaterial (2) im Schritt B) homogen eindispergiert wird.

6. Verfahren nach einem der vorhergehenden Ansprüche,
wobei das Konversionsmaterial (2) einen Anteil von einschließlich 50 Gew% bis einschließlich 60 Gew% in dem Matrixmaterial (41) aufweist.

7. Verfahren nach einem der vorhergehenden Ansprüche,
wobei nach Schritt F) ein zusätzlicher Schritt G) erfolgt: G) Aufbringen des Konversionselements (100) auf einen optoelektronischen Halbleiterchip (10).

8. Verfahren nach einem der vorhergehenden Ansprüche,
wobei vor Schritt F) ein zusätzlicher Schritt H) erfolgt: H) Aufbringen des nach Schritt E) gewaschenen Niederschlags (4) auf einen optoelektronischen Halbleiterchip (10) mittels Spraycoating.

9. Verfahren nach einem der vorhergehenden Ansprüche,
wobei im Schritt B) zusätzlich Streupartikel eindispergiert werden.

10. Verfahren nach einem der vorhergehenden Ansprüche,
wobei das saure Medium (1) aus einer Gruppe ausgewählt ist, die Salzsäure, Phosphorsäure, Salpetersäure, Schwefelsäure, Chlorsulfonsäure, Sulfurylchlorid, Perchlorsäure und Kombinationen daraus umfasst.

11. Verfahren nach einem der vorhergehenden Ansprüche,
wobei das saure Medium (1) in konzentrierter oder verdünnter Form vorliegt.

12. Verfahren nach einem der vorhergehenden Ansprüche,
wobei zumindest in einem der Schritte A) bis D) ein Indikator aus einem Peroxid zugegeben wird, der durch Farbumschlag die Vollständigkeit der Ausfällung des Niederschlags angibt.

13. Verfahren nach einem der vorhergehenden Ansprüche,
wobei nach Schritt F) ein zusätzlicher Schritt I) erfolgt: I) Schleifen des Konversionselements.

14. Verfahren nach einem der vorhergehenden Ansprüche,
wobei die Silikatlösung (3) im Schritt C) eine Lösung aus einem Natronwasserglas, Kaliwasserglas oder Lithiumwasserglas ist.

## Claims

1. A method for producing a conversion element (100) for an optoelectronic component (110) comprising the steps:
A) providing an acidic medium (1) with a pH value of less than 2,
B) adding a conversion material (2) into the acidic medium (1),
C) adding a silicate solution (3) with a viscosity of from 2 to 10 000 poise to the mixture obtained under step B) in such a way that the pH value during the addition in step C) is smaller than 2, wherein a precipitate (4) is obtained which contains the conversion material (2) and silicon dioxide (41) as matrix material,
D) separation of the precipitate (4),
E) washing the precipitate (4) with a washing medium (6), wherein the washing medium (6) has a pH value of less than 2,
F) curing the precipitate (4) in order to produce the conversion element (100).

2. Method according to claim 1,
wherein, before step F), the precipitate (4) is converted into a mold (8) and the curing (7) in step F) is carried out by means of a gas flow under pressure.

3. Method according to claim 2,
wherein the mold (8) comprises a screen.

4. Method according to one of the preceding claims,
wherein the conversion material (2) is selected from a group consisting of (Y,Lu,Gd,Tb)₃(Al₁₋ₓGaₓ)₅O₁₂, (Ba,Sr,Ca)Si₂O₂N₂, (Ba,Sr,Ca)₂SiO₄, (Ba,Sr,Ca)₂Si₅N₈, (Sr,Ca)AlSiN₃·Si₂N₂O, (Sr,Ca)AlSiN₃ and Ca₈Mg(SiO₄)₄Cl₂.

5. Method according to one of the preceding claims,
wherein the conversion material (2) is homogeneously dispersed in step B).

6. Method according to one of the preceding claims,
wherein the conversion material (2) has a proportion of 50 wt%, inclusive to 60 wt%, inclusive in the matrix material (41) .

7. Method according to one of the preceding claims,
wherein, after step F), an additional step G) is carried out: G) application of the conversion element (100) to an optoelectronic semiconductor chip (10).

8. Method according to one of the preceding claims,
wherein, before step F), an additional step H) is carried out:
H) application of the precipitate (4) washed after step E) to an optoelectronic semiconductor chip (10) by means of spray coating.

9. Method according to one of the preceding claims,
wherein in step B) scattering particles are additionally dispersed.

10. Method according to one of the preceding claims,
wherein the acidic medium (1) is selected from a group consisting of hydrochloric acid, phosphoric acid, nitric acid, sulphuric acid, chlorosulfonic acid, sulphuryl chloride, perchloric acid and combinations thereof.

11. Method according to one of the preceding claims,
wherein the acidic medium (1) is present in concentrated or diluted form.

12. Method according to one of the preceding claims,
wherein an indicator of a peroxide is added at least in one of steps A) to D), which indicates the completeness of the precipitation of the precipitate by color change.

13. Method according to one of the preceding claims,
wherein, after step F), an additional step I) is carried out: I) grinding of the conversion element.

14. Method according to one of the preceding claims,
wherein the silicate solution (3) in step C) is a solution of a sodium water glass, potassium water glass or lithium water glass.

## Revendications

1. Procédé de fabrication d'un élément de conversion (100) destiné à un composant optoélectronique (110), comportant les étapes:
A) mise à disposition d'un milieu acide (1) ayant un pH inférieur à 2,
B) ajout d'un matériau de conversion (2) au milieu acide (1),
C) ajout d'une solution de silicate (3) ayant une viscosité comprise entre 2 et 10000 poises au mélange produit à l'étape B), de sorte que la valeur pH soit inférieure à 2 pendant l'ajout dans l'étape C), le résultat étant un précipité (4) comprenant le matériau de conversion (2) et du dioxyde de silicium (41) comme matériau de matrice,
D) séparation du précipité (4),
E) lavage du précipité (4) à l'aide d'un agent de lavage (6), l'agent de lavage (6) présentant une valeur pH inférieure à 2,
F) trempage du précipité (4) pour obtenir l'élément de conversion (100).

2. Procédé selon la revendication 1,
dans lequel, avant l'étape F), le précipité (4) est transféré dans un moule (8) et le trempage (7) de l'étape F) est effectué au moyen d'un flux de gaz sous pression.

3. Procédé selon la revendication 2,
dans lequel le moule (8) comporte un tamis.

4. Procédé selon l'une des revendications précédentes,
dans lequel le matériau de conversion (2) est choisi dans un groupe comprenant (Y,Lu,Gd,Tb)₃(Al₁₋ₓGaₓ)₅O₁₂, (Ba,Sr,Ca)Si₂O₂N₂, (Ba,Sr,Ca)₂SiO₄, (Ba,Sr,Ca)₂Si₅N₈, (Sr,Ca)AlSiN₃·Si₂N₂O, (Sr,Ca)AlSiN₃ et CagMg(SiO₄)₄Cl₂.

5. Procédé selon l'une des revendications précédentes,
dans lequel le matériau de conversion (2) est dispersé de manière homogène dans l'étape B).

6. Procédé selon l'une des revendications précédentes,
dans lequel le matériau de conversion (2) présente une proportion comprise entre 50% en poids et 60% en poids dans le matériau de matrice (41).

7. Procédé selon l'une des revendications précédentes,
dans lequel une étape supplémentaire G) suit l'étape F) : G) dépôt de l'élément de conversion (100) sur une puce semi-conductrice optoélectronique (10).

8. Procédé selon l'une des revendications précédentes,
dans lequel
une étape H) supplémentaire précède l'étape F) :
H) dépôt du précipité (4) lavé suite à l'étape E) sur une puce semi-conductrice optoélectronique (10) par revêtement par pulvérisation.

9. Procédé selon l'une des revendications précédentes,
dans lequel dans l'étape B), des particules de dispersion sont dispersées en plus.

10. Procédé selon l'une des revendications précédentes,
dans lequel le milieu acide (1) est choisi dans le groupe comprenant l'acide chlorhydrique, l'acide phosphorique, l'acide nitrique, l'acide sulfurique, l'acide chlorosulfonique, le chlorure de sulfuryle, l'acide perchlorique et leurs combinaisons.

11. Procédé selon l'une des revendications précédentes,
dans lequel le milieu acide (1) est présent sous forme concentrée ou diluée.

12. Procédé selon l'une des revendications précédentes,
dans lequel au moins dans l'une des étapes A) à D), un indicateur d'un peroxyde est ajouté, indiquant par changement de couleur l'intégralité de la précipitation du précipité.

13. Procédé selon l'une des revendications précédentes,
dans lequel une étape supplémentaire I) suit l'étape F) : I) polissage de l'élément de conversion.

14. Procédé selon l'une des revendications précédentes,
dans lequel la solution de silicate (3) de l'étape C) est une solution de silicate de sodium, de silicate de potassium ou de verre soluble au lithium.
